(19) **Europäisches Patentamt / European Patent Office / Office européen des brevets**

(11) **EP 3 259 380 B1**

(12) **FASCICULE DE BREVET EUROPEEN**

(45) Date de publication et mention
de la délivrance du brevet:
**24.10.2018 Bulletin 2018/43**

(21) Numéro de dépôt: **16709812.8**

(22) Date de dépôt: **22.01.2016**

(51) Int Cl.:
*C23C 2/12* (2006.01)     *C23C 2/26* (2006.01)
*C23C 2/40* (2006.01)     *C23C 28/02* (2006.01)
*C23C 14/02* (2006.01)    *C23C 14/16* (2006.01)
*C23C 14/58* (2006.01)    *B32B 15/01* (2006.01)
*C21D 9/46* (2006.01)

(86) Numéro de dépôt international:
**PCT/IB2016/000037**

(87) Numéro de publication internationale:
**WO 2016/132194 (25.08.2016 Gazette 2016/34)**

(54) **PROCEDE DE FABRICATION D'UNE PIECE PHOSPHATABLE A PARTIR D'UNE TÔLE REVÊTUE D'UN REVÊTEMENT A BASE D'ALUMINIUM ET D'UN REVÊTEMENT DE ZINC**

VERFAHREN ZUR HERSTELLUNG EINES PHOSPHATIERBAREN TEILS AUS EINEM BLECH MIT BESCHICHTUNG AUF ALUMINIUMBASIS UND ZINKBESCHICHTUNG

METHOD OF PRODUCING A PHOSPHATABLE PART FROM A SHEET COATED WITH AN ALUMINIUM-BASED COATING AND A ZINC COATING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.02.2015 PCT/IB2015/000194**

(43) Date de publication de la demande:
**27.12.2017 Bulletin 2017/52**

(73) Titulaire: **Arcelormittal**
**1160 Luxembourg (LU)**

(72) Inventeurs:
• **ALLELY, Christian**
**F- Maizières-lès-Metz (FR)**

• **JACQUESON, Eric**
**F-57050 Longeville les Metz (FR)**
• **CHALEIX, Daniel**
**F-57420 Verny (FR)**

(74) Mandataire: **Lavoix**
**2, place d'Estienne d'Orves**
**75441 Paris Cedex 09 (FR)**

(56) Documents cités:
**EP-A1- 2 045 360      WO-A1-2014/037627**
**US-A1- 2012 085 466**

**Description**

L'invention concerne un procédé de préparation de pièces d'acier durcies sous presse fabriquées à partir de tôles revêtues d'un revêtement à base d'aluminium et d'un revêtement de zinc. La pièce présente de bonnes caractéristiques vis-à-vis de la phosphatation, et par conséquent présente une bonne adhérence de la peinture. Elle est notamment destinée à la fabrication de pièces de véhicules automobiles.

Les pièces durcies sous presse peuvent être revêtues d'un alliage à base d'aluminium qui a de bonnes propriétés anticorrosion et de bonnes propriétés thermiques. Généralement, le procédé de préparation de ces pièces comprend l'approvisionnement d'une tôle d'acier, la découpe de la tôle pour obtenir un flan, le chauffage du flan, un emboutissage à chaud suivi d'un refroidissement pour obtenir un durcissement par transformation martensitique, soit martensito-bainitique, soit de sorte que la structure de l'acier soit constituée d'au moins 75% de ferrite équiaxe, de martensite en quantité supérieure ou égale à 5% et inférieure ou égale à 20%, et de bainite en quantité inférieure ou égale à 10%. Les pièces durcies ainsi obtenues ont de très hautes caractéristiques mécaniques.

Habituellement, on ajoute un film de peinture sur les pièces durcies sous presse, notamment une couche de cataphorèse. Préalablement, une phosphatation est souvent réalisée. Ainsi, des cristaux de phosphate se forment sur la surface de la pièce durcie à revêtir, augmentant l'adhérence de la peinture, et notamment de la couche de cataphorèse.

Les pièces revêtues d'un alliage à base d'aluminium ne sont pas phosphatables, c'est-à-dire qu'il n'y a pas de cristaux de phosphate qui se forment à la surface du revêtement. L'ajout du film de peinture est donc directement réalisé sans phosphatation au préalable. La microrugosité de la surface des pièces revêtues d'un alliage à base d'aluminium permet une adhérence de la peinture. Néanmoins, dans certaines conditions, la peinture n'est pas répartie de façon homogène sur la surface de la pièce engendrant des zones de rouille rouge. La rouille rouge apparait dans les zones où la peinture est trop ancrée dans le revêtement à base d'aluminium.

On connaît la demande de brevet EP2270257. Elle divulgue une tôle d'acier pour emboutissage à chaud comprenant un premier revêtement à base d'aluminium, et un deuxième revêtement comprenant un composé ayant une structure wurtzite, de préférence le composé est l'oxyde de zinc (ZnO). Le revêtement de ZnO permet de réaliser une phosphatation après le procédé de durcissement sous presse. Cependant, en pratique, la mise en oeuvre de ce procédé engendre un taux de couvrance des cristaux de phosphate relativement faible sur la surface de la pièce, de l'ordre de 20 à 70%. Ce taux de couvrance n'est pas acceptable puisqu'il ne permet pas une bonne adhérence de la peinture sur la surface de la pièce.

On connaît aussi la demande brevet US 2012/0085466 A1. Elle divulgue une tôle d'acier pour durcissement sous presse (e.g. 22MnB5) revêtue d'un premier revêtement à base d'aluminium d'une épaisseur de comprise entre 10 et 30 $\mu$m, et d'un second revêtement de zinc d'une épaisseur comprise entre 2 et 10 $\mu$m.

La présente invention a pour but de remédier aux inconvénients de l'art antérieur en mettant à disposition une pièce durcie sous presse phosphatable, et par conséquent présentant une bonne adhérence de la peinture, à partir d'une tôle d'acier revêtue. Elle vise à mettre à disposition, en particulier, une pièce durcie sous presse pouvant être phosphatée de manière à obtenir un taux de couvrance élevé des cristaux de phosphate sur la surface de la pièce, c'est-à-dire un taux supérieur ou égal à 80%.

Elle vise en outre à mettre à disposition un procédé de préparation de ladite tôle d'acier.

Elle vise encore à mettre à disposition un procédé de fabrication d'une pièce durcie sous presse phosphatable, dans des conditions de productivités avantageuses.

Elle vise encore l'utilisation d'une pièce durcie sous presse pour la fabrication de pièces de véhicules automobiles.

A cet effet, l'invention a pour objet une tôle d'acier selon la revendication 1. La tôle d'acier peut en outre comprendre les caractéristiques des revendications 2 à 9.

L'invention a également pour objet un procédé de préparation de la tôle d'acier revêtue selon la revendication 10. Ce procédé de préparation peut également comprendre les caractéristiques des revendications 11 à 13.

L'invention a également pour objet un procédé de préparation d'une pièce durcie sous presse selon la revendication 14. Ce procédé de préparation peut également comprendre les caractéristiques des revendications 15 à 16.

L'invention a également pour objet une pièce durcie sous presse selon la revendication 17. Cette pièce peut comprendre les caractéristiques des revendications 18 à 20.

L'invention a enfin pour objet l'utilisation d'une pièce durcie sous presse selon la revendication 21.

D'autres caractéristiques et avantages de l'invention apparaitront à la lecture de la description qui va suivre.

Afin d'illustrer l'invention, différents modes de réalisation et essais à titre d'exemples non limitatifs vont être décrits, notamment en référence aux figures qui représentent :

La figure 1 est une représentation schématique d'une tôle d'acier revêtue selon un mode de réalisation de l'invention.
La figure 2 est une représentation schématique d'une tôle d'acier revêtue selon un autre mode de réalisation de l'invention.

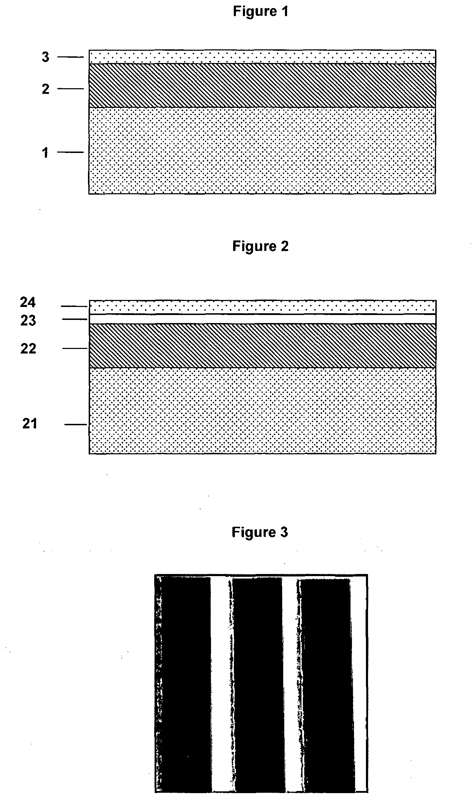

Pour les figures 1 et 2, l'épaisseur des couches représentée n'est donnée qu'à titre d'illustration et ne peut être considérée comme une représentation à l'échelle des différentes couches.

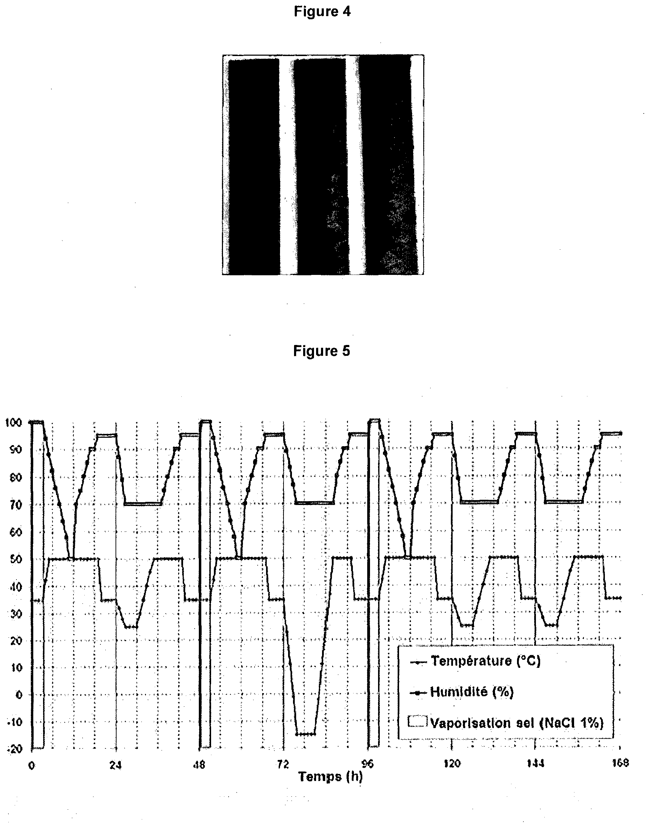

Les figures 3 et 4 représentent deux faces de pièces durcies en taille réelle à partir de tôles d'acier munies d'un premier revêtement à base d'aluminium dont l'épaisseur est de 25μm et sur une face d'un deuxième revêtement de zinc déposé par électrodéposition dont l'épaisseur est de 1, 2 et 3μm.

La figure 5 représente le cycle de corrosion de la norme VDA 231-102. On définira les termes suivants :

- « revêtement de zinc » désigne un revêtement comprenant majoritairement du zinc et éventuellement des impuretés. De préférence, le revêtement contient du zinc et éventuellement des impuretés,
- « revêtement à base d'aluminium » désigne un revêtement comprenant une quantité d'aluminium supérieure à 50% en poids, de préférence supérieure ou égale à 70% en poids, de préférence encore supérieure ou égale à 85% en poids, avantageusement supérieure ou égale à 88% en poids. Ce revêtement peut être allié ou non allié,
- « taux de couvrance des cristaux de phosphate» est défini par un pourcentage. 0% signifie que la surface de la pièce n'est pas du tout recouverte de cristaux de phosphate, 100% signifie que la surface de la pièce est quant à elle entièrement recouverte.

Pour l'ensemble des figures 1 à 5 et pour la suite de l'invention, la dénomination « acier » ou « tôle d'acier » se réfère à une tôle d'acier pour durcissement sous presse présentant une composition permettant à la pièce d'atteindre une résistance en traction supérieure ou égale à 500 MPa, de préférence supérieure ou égale à 1000 MPa, avantageusement supérieure ou égale à 1500 MPa. La composition pondérale de la tôle d'acier est de préférence la suivante: $0,03\% \leq C \leq 0,50\%$ ; $0,3\% \leq Mn \leq 3,0\%$ ; $0,05\% \leq Si \leq 0,8\%$ ; $0,015\% \leq Ti \leq 0,2\%$ ; $0,005\% \leq Al \leq 0,1\%$ ; $0\% \leq Cr \leq 2,50\%$ ; $0\% \leq S \leq 0,05\%$ ; $0\% \leq P \leq 0,1\%$ ; $0\% \leq B \leq 0,010\%$ ; $0\% \leq Ni \leq 2,5\%$ ; $0\% \leq Mo \leq 0,7\%$ ; $0\% \leq Nb \leq 0,15\%$ ; $0\% \leq N \leq 0,015\%$ ; $0\% \leq Cu \leq 0,15\%$ ; $0\% \leq Ca \leq 0,01\%$ ; $0\% \leq W \leq 0,35\%$, le reste de la composition étant constitué de fer et d'impuretés inévitables résultant de l'élaboration.

Par exemple, la tôle d'acier est une tôle 22MnB5 dont la composition pondérale est la suivante :

$0,20\% \leq C \leq 0,25\%$
$0,15\% \leq Si \leq 0,35\%$
$1,10\% \leq Mn \leq 1,40\%$
$0\% \leq Cr \leq 0,30\%$
$0\% \leq Mo \leq 0,35\%$
$0\% \leq P \leq 0,025\%$
$0\% \leq S \leq 0,005\%$
$0,020\% \leq Ti \leq 0,060\%$
$0,020\% \leq Al \leq 0,060\%$
$0,002\% \leq B \leq 0,004\%$,

le reste de la composition étant constituée de fer et d'impuretés inévitables résultant de l'élaboration.

La tôle d'acier peut également être une tôle Usibor®2000 dont la composition pondérale est la suivante :

$0,24\% \leq C \leq 0,38\%$
$0,40\% \leq Mn \leq 3\%$
$0,10\% \leq Si \leq 0,70\%$
$0,015\% \leq Al \leq 0,070\%$
$0 \% \leq Cr \leq 2\%$
$0,25\% \leq Ni \leq 2\%$
$0,020\% \leq Ti \leq 0,10\%$
$0\% \leq Nb \leq 0,060\%$
$0,0005\% \leq B \leq 0,0040\%$
$0,003\% \leq N \leq 0,010\%$
$0,0001 \% \leq S \leq 0,005\%$
$0,0001 \% \leq P \leq 0,025\%$

étant entendu que les teneurs en titane et en azote satisfont à :

Ti/N > 3,42,

et que les teneurs en carbone, manganèse, chrome et silicium satisfont à :

$$2,6C + \frac{Mn}{5,3} + \frac{Cr}{13} + \frac{Si}{15} \geq 1,1\%$$

la composition comprenant optionnellement un ou plusieurs des éléments suivants :

0,05% ≤ Mo ≤ 0,65%
0,001% ≤ W ≤ 0,30%
0,0005% ≤ Ca ≤ 0,005%,

le reste de la composition étant constituée de fer et d'impuretés inévitables résultant de l'élaboration.

Par exemple encore, la tôle d'acier est une tôle Ductibor®500 dont la composition pondérale est la suivante :

0,040% ≤ C ≤ 0,100%
0,80% ≤ Mn ≤ 2,00%
0% ≤ Si ≤ 0,30%
0% ≤ S ≤ 0,005%
0% ≤ P ≤ 0,030%
0,010% ≤ Al ≤ 0,070%
0,015% ≤ Nb ≤ 0,100%
0,030% ≤ Ti ≤ 0,080%
0% ≤ N ≤ 0,009%
0% ≤ Cu ≤ 0,100%
0% ≤ Ni ≤ 0,100%
0% ≤ Cr ≤ 0,100%
0% ≤ Mo ≤ 0,100%
0% ≤ Ca ≤ 0,006%,

le reste de la composition étant constituée de fer et d'impuretés inévitables résultant de l'élaboration.

Les tôles d'acier sont fabriquées par laminage à chaud et peuvent éventuellement être re-laminées à froid en fonction de l'épaisseur désirée.

Comme on l'aura compris, tout d'abord, l'invention porte sur une tôle d'acier revêtue. La figure 1 représente un mode de réalisation de la tôle 1 selon l'invention. Elle est munie d'un revêtement à base d'aluminium 2 comprenant en outre un deuxième revêtement de zinc 3 dont l'épaisseur est inférieure ou égale à 1,1 μm ; de préférence inférieure ou égale à 1,0 μm ; de préférence encore inférieure ou égale à 0,7 μm et préférentiellement inférieure ou égale à 0,5 μm. Avantageusement, le revêtement de zinc présente une épaisseur supérieure ou égale à 0,1 μm.

Sans vouloir être lié par une théorie, il semble que si ces conditions d'épaisseur ne sont pas remplies, et notamment si l'épaisseur de Zinc est trop importante ; tout le zinc n'est pas oxydé en oxyde de zinc (ZnO) assez rapidement lors du traitement thermique. En effet, l'oxygène présent dans le four va mettre plus longtemps à diffuser dans le revêtement de zinc pour l'oxyder complètement. En conséquence, une partie du zinc va rester à l'état liquide plus longtemps, le zinc encore liquide va diffuser vers le revêtement à base d'aluminium puis vers l'acier. Le zinc qui a diffusé en profondeur dans le substrat peut engendrer une fragilisation et une perte d'adhérence des couches supérieures, c'est-à-dire du revêtement à base d'aluminium et de la couche de cataphorèse.

En outre, il est également possible si ces conditions d'épaisseur ne sont pas remplies que la microrugosité de surface augmente avec l'épaisseur du revêtement de zinc favorisant ainsi les zones de rouille rouge après le dépôt de la couche de cataphorèse.

Ainsi, dans la plupart des cas, le taux de couvrance des cristaux de phosphate est faible, il y a alors un risque de mauvaise adhérence de la couche de cataphorèse. Cependant, dans certains cas, bien que le taux de couvrance des cristaux de phosphate soit élevé, il y a un risque de perte d'adhérence de la couche de cataphorèse et de mauvaise résistance à la rouille rouge sous cette couche de cataphorèse.

Enfin, il y a un risque que le zinc, restant liquide trop longtemps, pollue le four dans lequel a lieu le traitement thermique.

Le revêtement à base d'aluminium est de préférence réalisé par trempage à chaud dans un bain métallique fondu. Habituellement, le bain comprend jusqu'à 3% de fer et de 9 à 12% de silicium, le reste étant de l'aluminium. L'épaisseur de la couche est par exemple comprise entre 5 et 50 μm, de préférence entre 10 et 35 μm. Lors du traitement thermique précédant la déformation à chaud, le revêtement forme une couche alliée présentant une grande résistance à la corrosion, à l'abrasion, à l'usure et à la fatigue.

De préférence, le produit de l'épaisseur du revêtement à base d'aluminium et de l'épaisseur du revêtement de zinc est compris entre 2 et 25, de préférence entre 4 et 25, de préférence encore entre 4 et 16, et avantageusement entre 6 et 13 ; l'épaisseur du revêtement de zinc étant inférieure ou égale à 1,1$\mu$m, de préférence inférieure ou égale à 1,0$\mu$m, de préférence encore inférieure ou égale à 0,7$\mu$m et préférentiellement inférieure ou égale à 0,5$\mu$m.

Sans vouloir être lié par une théorie, il est possible que si ces conditions ne sont pas remplies, en particulier si l'épaisseur du revêtement à base d'aluminium est trop grande, le revêtement à base d'Aluminium reste plus longtemps en phase liquide. Par conséquent, la couche de ZnO formée lors du début du traitement thermique et le revêtement à base d'Aluminium vont interagir pendant une longue période. Cette interaction peut résulter en une réduction de la couche de ZnO en Zn par l'aluminium, ce processus étant gouverné par une cinétique lente.

Le revêtement de zinc 3 peut être déposé par tout procédé approprié, par exemple par cémentation, par électrodéposition ou par dépôt sous vide par jet de vapeur sonique (JVD ou jet vapour deposition).

Selon un mode de réalisation, le revêtement de zinc est réalisé par électrodéposition, il est réalisé par exemple par immersion dans un bain de sulfate de zinc ($ZnSO_4$). Avantageusement, la température du bain T3 est inférieure à 70°C, de préférence T3 va de 50 à 60°C.

Selon un autre mode de réalisation, le revêtement de zinc est déposé par cémentation. Lorsque le revêtement de zinc est réalisé par cémentation, il est réalisé soit par aspersion, soit par immersion. Ainsi, la tôle d'acier revêtue d'un revêtement métallique à base d'aluminium est immergée dans un bain ou aspergée d'une solution comprenant de l'hydroxyde de sodium (NaOH) et de l'oxyde de zinc (ZnO). Avantageusement, l'immersion ou l'aspersion est réalisée pendant un temps t4 allant de 1 à 20 secondes, de préférence de t4 va de 5 à 10 secondes. Elle est réalisée à une température T4 allant de 40 à 60°C, de préférence T4 est de 60°C.

Sans vouloir être lié à une théorie, le mélange de NaOH et ZnO permet de former du zincate de sodium ($Na_2ZnO_2$), selon la réaction suivante : $2NaOH + ZnO \rightarrow Na_2ZnO_2 + H_2O$. Ensuite, $Na_2ZnO_2$ va réagir avec l'aluminium présent dans le revêtement à base d'aluminium pour former le revêtement de zinc sur la tôle d'acier revêtue du revêtement à base d'aluminium selon la réaction suivante : $2Al + 3Na_2ZnO_2 + 2H_2O \rightarrow 3Zn + 2NaAlO_2 + 4NaOH$.

Selon un autre mode de réalisation, le revêtement de zinc est déposé par dépôt sous vide par jet de vapeur sonique. Selon ce mode de réalisation, la vapeur métallique de zinc est générée en chauffant par induction un creuset contenant un bain constitué par du zinc chauffé à une température T5 d'au moins 600°C, de préférence T5 est de 700°C, dans une enceinte sous vide à une pression $P_5$ comprise de préférence entre $6.10^{-2}$ et $2.10^{-1}$ mbar. La vapeur s'échappe du creuset par une conduite qui l'amène vers un orifice de sortie, de préférence calibré, de manière à former un jet à vitesse sonique dirigé vers la surface du substrat à revêtir.

Avantageusement, avant le dépôt de zinc réalisé par JVD, la tôle d'acier munie d'un revêtement à base d'aluminium est recouverte d'une fine couche d'acier inoxydable comprenant au moins 10% en poids de chrome, le reste étant du fer, des éléments additionnels tels que le nickel, le carbone, le molybdène, le silicium, le manganèse, le phosphore ou le soufre et les impuretés liées au processus de fabrication. De préférence, la couche d'acier inoxydable comprend au moins 10% en poids de chrome, au moins 8% en poids de nickel, le reste étant du fer, des éléments additionnels tels que décris précédemment et les impuretés liées au processus de fabrication. Cette couche est préférentiellement de l'inox 316 dont la composition pondérale est la suivante : $16 \leq Cr \leq 18\%$ et $10 \leq Ni \leq 14\%$. Par exemple, cette couche est de l'inox 316L dont la composition pondérale est la suivante : C = 0,02% ; $16 \leq Cr \leq 18\%$ ; $10,5 \leq Ni \leq 13\%$ ; $2 \leq Mo \leq 2,5\%$, Si = 1% ; Mn = 2% ; P = 0,04% et S = 0,03%. Son épaisseur peut être, par exemple, supérieure ou égale à 2 nm, de préférence comprise entre 2 et 15 nm. La figure 2 représente ce mode de réalisation dans lequel la tôle 21 est revêtue d'un revêtement à base d'aluminium 22, d'une fine couche d'acier inoxydable 23, et d'un troisième revêtement de zinc 24. La couche d'acier inoxydable peut être déposée par tout procédé connu de l'homme du métier. Elle est, par exemple, déposée par électrodéposition ou par pulvérisation cathodique magnétron.

Quel que soit le procédé de dépôt utilisé pour ajouter le revêtement de zinc, un dégraissage alcalin peut être réalisé pour augmenter l'adhérence de la couche de revêtement de zinc. Avantageusement, le dégraissage est réalisé à l'aide d'un bain chimique alcalin comprenant, par exemple, NaOH et/ou de l'hydroxyde de potassium (KOH), et des tensioactifs. Le dégraissage est avantageusement réalisé par immersion ou aspersion pendant une durée t6 allant de 1 à 120 secondes, de préférence de 2 à 20 secondes. La température du dégraissage T6 va de 30°C à 90°C, de préférence T6 est de 60°C. Le pH du bain va de 10 à 14.

Un dégraissage acide peut également être envisagé: Dans ce cas, le bain chimique comprend, par exemple, de l'acide phosphorique ($H_3PO_4$) et des tensioactifs. Le pH du bain va de 0 à 2.

Quel que soit le type de dégraissage mis en oeuvre, il est généralement suivi d'un rinçage.

Les tôles d'acier selon l'invention sont ensuite durcies sous presse. Ce procédé consiste à approvisionner une tôle d'acier préalablement revêtue selon l'invention, puis à découper la tôle pour obtenir un flan. Ce flan est ensuite chauffé dans une atmosphère non protectrice jusqu'à la température d'austénisation T1 de l'acier qui va de 840 à 950°C, de préférence de 840 à 930°C. De préférence, le flan est chauffé pendant une durée t1 allant de 3 à 12 minutes, préférentiellement de 4 à 10 minutes, dans une atmosphère inerte ou une atmosphère comprenant de l'air. Lors de ce traitement thermique, le revêtement de zinc est oxydé en ZnO.

Après le traitement thermique, le flan est transféré vers un outil d'emboutissage à chaud puis embouti à chaud à une température T2 allant de 600 à 830°C. La pièce obtenue est ensuite refroidie soit dans l'outil d'emboutissage lui-même, soit après transfert dans un outil de refroidissement spécifique.

La vitesse de refroidissement est contrôlée en fonction de la composition de l'acier, afin que sa microstructure finale à l'issue de l'emboutissage à chaud comprenne soit majoritairement la martensite, de préférence contienne la martensite, soit la martensite et la bainite ou soit constituée d'au moins 75% de ferrite équiaxe, de martensite en quantité supérieure ou égale à 5% et inférieure ou égale à 20%, et de bainite en quantité inférieure ou égale à 10%.

On obtient ainsi une pièce durcie sous presse phosphatable selon l'invention comprenant une couche de ZnO.

Pour les applications automobiles, après phosphatation, on trempe chaque pièce dans un bain de cataphorèse. On peut également envisager d'appliquer ensuite successivement, une couche de peinture d'apprêt, une couche de peinture de base et éventuellement une couche de vernis de finition.

Avant d'appliquer la couche de cataphorèse sur la pièce, celle-ci est préalablement dégraissée puis phosphatée de manière à assurer l'adhérence de la cataphorèse. Après la phosphatation d'une pièce durcie selon l'invention, on obtient une pièce durcie sous presse comprenant une couche de ZnO et en outre une couche de cristaux de phosphate sur la couche de ZnO. Le taux de couvrance des cristaux de phosphate sur la surface de la pièce durcie est élevé. De préférence, le taux de couvrance des cristaux de phosphate sur la surface de la pièce est supérieur ou égal à 80%, de préférence encore supérieur ou égal à 90% et avantageusement supérieur ou égal à 99%.

La couche de cataphorèse assure à la pièce une protection complémentaire contre la corrosion. La couche de peinture d'apprêt, généralement appliquée au pistolet, prépare l'apparence finale de la pièce et la protège contre le gravillonnage et contre les UV. La couche de peinture de base confère à la pièce sa couleur et son apparence finale. La couche de vernis confère à la surface de la pièce une bonne résistance mécanique, une résistance contre les agents chimiques agressifs et un bon aspect de surface.

Généralement, l'épaisseur de la couche de phosphatation est compris entre 1 et 2$\mu$m. Les films de peinture mis en oeuvre pour protéger et garantir un aspect de surface optimal aux pièces, comprennent par exemple une couche de cataphorèse de 8 à 25 $\mu$m d'épaisseur, une couche de peinture d'apprêt de 35 à 45 $\mu$m d'épaisseur et une couche de peinture de base de 40 à 50 $\mu$m d'épaisseur.

Dans les cas où les films de peinture comprennent en outre une couche de vernis, les épaisseurs des différentes couches de peinture sont généralement les suivantes :

- couche de cataphorèse : entre 8 et 25$\mu$m, de préférence inférieure à 20$\mu$m,
- couche de peinture d'apprêt : inférieure à 45$\mu$m,
- couche de peinture de base : inférieure à 20$\mu$m, et couche de vernis : inférieure à 55 $\mu$m.

De préférence, l'épaisseur totale des films de peinture sera inférieure à 120 $\mu$m, voire 100 $\mu$m.

L'invention va à présent être explicitée par des essais réalisés à titre indicatif et non limitatif.

## Exemples

Pour l'ensemble des essais, les aciers suivant sont utilisés : Usibor®1500 ou 22MnB5. Ils sont revêtus par un revêtement à base d'aluminium comprenant 9% en poids de silicium, 3% de fer et 88% d'aluminium dont l'épaisseur est de 14 ou 25 $\mu$m.

La composition pondérale de la tôle d'acier Usibor®1500 utilisée dans les exemples est la suivante : C = 0,2252% ; Mn = 1,1735% ; P = 0,0126%, S = 0,0009% ; N = 0,0037% ; Si = 0,2534% ; Cu = 0,0187% ; Ni = 0,0197% ; Cr = 0,180% ; Sn = 0,004% ; Al = 0,0371% ; Nb = 0,008% ; Ti = 0,0382% ; B = 0,0028 % ; Mo = 0,0017% ; As = 0,0023% et V = 0,0284%.

Par exemple, « Usibor® AluSi® 14 $\mu$m » signifie qu'il s'agit d'un acier Usibor®1500 tel que défini précédemment munie d'un revêtement à base d'aluminium comprenant 9% en poids de silicium, 3% de fer et 88% d'aluminium dont l'épaisseur est de 14 $\mu$m.

Par exemple, « 22MnB5 AlSi 14 $\mu$m » signifie qu'il s'agit d'un acier 22MnB5 munie d'un revêtement à base d'aluminium comprenant 9% en poids de silicium, 3% de Fer et 88% d'aluminium dont l'épaisseur est de 14 $\mu$m.

## Exemple 1 : Test de phosphatabilité et Test de comportement du zinc:

Le test de phosphatabilité sert à déterminer la répartition des cristaux de phosphate sur la pièce durcie sous presse, notamment en évaluant le taux de couvrance sur la surface de la pièce.

## Exemple 1a :

Tout d'abord, on réalise une série de 3 échantillons, nommés 1, 2 et 3.

Les échantillons 1 et 2 sont obtenus à partir d'une tôle d'acier 22MnB5 munie d'un premier revêtement à base d'aluminium et d'un deuxième revêtement de ZnO dont l'épaisseur est de 0,2μm selon le procédé décrit dans EP2270257.

L'échantillon 3 est obtenu à partir d'une tôle d'acier Usibor® AluSi® 25μm.

L'échantillon 4 est obtenu à partir d'une tôle d'acier Usibor® AluSi® 25μm munie en outre d'un revêtement de zinc déposé par cémentation dont l'épaisseur est de 0,17μm. Le dépôt de zinc est réalisé par immersion dans un bain comprenant NaOH à une concentration de 150g.L$^{-1}$ et ZnO à une concentration de 15g.L$^{-1}$ pendant 5 secondes. La température du bain est de 60°C.

Pour chacun des échantillons, on a découpé la tôle d'acier revêtue pour obtenir un flan. Puis on a chauffé le flan à une température de 900°C pendant une durée allant de 5 minutes à 5 minutes et 30 secondes. On a ensuite transféré le flan au sein d'une presse, puis on a embouti à chaud pour obtenir une pièce. Enfin, on a refroidi ladite pièce pour obtenir un durcissement par transformation martensitique.

Un dégraissage est ensuite réalisé à l'aide d'une solution de Gardoclean® 5176 et de Gardobond® H 7352 à une température de 55°C. Il est suivi d'un rinçage à l'eau. La surface de la pièce est alors activée avec une solution de Gardolene® V6513 par immersion à température ambiante. Enfin, la phosphatation est réalisée par immersion pendant 3 minutes dans un bain comprenant une solution de Gardobond® 24 TA à une température de 50°C. La pièce est rincée avec de l'eau puis séchée à l'air chaud. On a observé la surface de ces échantillons phosphatés par MEB. Les résultats sont indiqués dans le tableau ci-dessous :

| Echantillon | 1 (selon EP2270257) | 2 (selon EP2270257) | 3 | 4 |
|---|---|---|---|---|
| Tôle d'acier | 22MnB5 AlSi 14μm + ZnO | 22MnB5 AlSi 25μm + ZnO | Usibor® AluSi® 25μm | Usibor® AluSi® 25μm + Zn |
| Durée chauffage à 900°C | 5 minutes 30 secondes | 5 minutes 30 secondes | 5 minutes | 5 minutes |
| Type de dépôt | ZnO déposé par enduction | ZnO déposé par enduction | X | Zn déposé par cémentation |
| Epaisseur couche | 0,2μm | 0,2μm | X | 0,17μm |
| Taux de couvrance | 65% | 20% | 0% | >99% |

On remarque que seul l'échantillon 4 présente un taux de couvrance élevé des cristaux de phosphate sur la pièce durcie.

Exemple 1b :

On réalise une autre série d'échantillons, nommés 4, 5 et 6.

L'échantillon 4 est obtenu à partir d'une tôle d'acier Usibor® AluSi® 25μm munie en outre sur une face de la tôle d'un deuxième revêtement de zinc déposé par électrodéposition dont l'épaisseur est de 1μm.

L'échantillon 5 est obtenu à partir d'une tôle d'acier Usibor® AluSi® 25μm munie en outre sur une face de la tôle d'un deuxième revêtement de zinc déposé par électrodéposition dont l'épaisseur est de 2μm.

L'échantillon 6 est obtenu à partir d'une tôle d'acier Usibor® AluSi® 25μm munie en outre sur une face de la tôle d'un deuxième revêtement de zinc déposé par électrodéposition dont l'épaisseur est de 3μm.

Pour le dépôt de zinc par électrodéposition, tout d'abord, un dégraissage de la tôle est réalisé à l'aide d'une solution de Novaclean® 301 à une température de 80°C par immersion pendant 3 secondes. Le dégraissage est suivi d'un rinçage à l'eau. Ensuite, un avivage est réalisé avec une solution d'acide sulfurique à température ambiante par immersion pendant 4 secondes. L'avivage est suivi d'un rinçage à l'eau. La tôle est alors immergée dans un bain électrolytique comprenant de l'acide sulfurique ($H_2SO_4$) et du sulfate de zinc ($ZnSO_4$) à une température de 50°C. La densité de courant appliquée sur la tôle d'acier est de 80 A/dm$^2$. Le pH du bain est de 0,8.

Le procédé de durcissement sous presse décrit dans l'Exemple 1a est ensuite appliqué à ces échantillons. Dans ce cas, on a chauffé le flan à une température T1 de 900°C pendant une durée t1 de 6 minutes et 30 secondes. On a observé la surface de ces échantillons phosphatés par MEB. Les résultats sont indiqués dans le tableau ci-dessous :

| Echantillon | 4 | 5 | 6 |
|---|---|---|---|
| Tôle d'acier | Usibor® AluSi® 25μm + Zn | Usibor® AluSi® 25μm + Zn | Usibor® AluSi® 25μm + Zn |

(suite)

| Echantillon | 4 | 5 | 6 |
|---|---|---|---|
| Type de dépôt | Zn déposé par électrodéposition | Zn déposé par électrodéposition | Zn déposé par électrodéposition |
| Epaisseur couche | 1$\mu$m | 2$\mu$m | 3$\mu$m |
| Taux de couvrance | 95% | 60% | 65% |

On remarque que seul l'échantillon 4 présente un taux de couvrance élevé des cristaux de phosphate sur la surface de la pièce durcie.

On a également observé le comportement du zinc pendant le traitement thermique à 900°C pour chacun des échantillons 4 à 6. Nous avons étudié le comportement du zinc sur la face où il y a eu le dépôt de zinc et sur la face opposée qui n'a pas été revêtue de zinc. Les figures 9 et 10 représentent les échantillons 4, 5 et 6 disposés dans cet ordre. Les résultats sont indiqués dans le tableau ci-dessous :

| Echantillon | 4 | 5 | 6 |
|---|---|---|---|
| Epaisseur couche | 1$\mu$m | 2$\mu$m | 3$\mu$m |
| Figure | 3 | | |
| Comportement du zinc sur la face où il y a eu le dépôt de zinc | Bon comportement | Bon comportement | Bon comportement |
| Figure | 4 | | |
| Aspect de la face opposée | Bon comportement | Diffusion du zinc sur la face opposée | Diffusion du zinc sur la face opposée |

On remarque que le comportement du zinc pendant le traitement thermique est bon, c'est-à-dire qu'il n'y a rien à signaler pour l'échantillon 4. En revanche, lorsque l'épaisseur de la couche de zinc est égale à 2 ou 3$\mu$m (échantillons 5 et 6), le zinc diffuse sur la face opposée. La diffusion du zinc est néfaste à l'échelle industrielle dans le four dans lequel il y a le traitement thermique d'austénisation et sous la presse d'emboutissage.

Exemple 1c :

On réalise une autre série d'échantillons, nommés 7, 8 et 9.

Les échantillons sont obtenus à partir de tôles d'aciers Usibor® AluSi® 14$\mu$m munies en outre sur une face de la tôle d'un deuxième revêtement de zinc déposé par électrodéposition à l'aide d'un bain de sulfate de zinc. Selon les échantillons, l'épaisseur du revêtement de zinc varie de 0,5$\mu$m à 1,5$\mu$m.

Pour le dépôt de zinc par électrodéposition, tout d'abord, un dégraissage de la tôle est réalisé à l'aide d'une solution de Novaclean® 301 à une température de 80°C par immersion pendant 3 secondes. Le dégraissage est suivi d'un rinçage à l'eau. Ensuite, un avivage est réalisé avec une solution d'acide sulfurique à température ambiante par immersion pendant 4 secondes. L'avivage est suivi d'un rinçage à l'eau. La tôle est alors immergée dans un bain électrolytique comprenant $H_2SO_4$ et $ZnSO_4$ à une température de 50°C. La densité de courant appliquée sur la tôle d'acier est de 15 A/dm$^2$. Le pH du bain est de 3.

Pour chacun des échantillons, la tôle revêtue est découpée pour obtenir un flan. Puis on a chauffé le flan à une température de 900°C pendant une durée de 5 minutes et 30 secondes. On a ensuite transféré le flan au sein d'une presse, puis on a on embouti à chaud pour obtenir une pièce. Enfin, on a refroidi ladite pièce pour obtenir un durcissement par transformation martensitique.

Un dégraissage et une phosphatation tels que définis dans l'Exemple 1a ont été ensuite réalisés sur les pièces durcies obtenues. On a observé la surface de ces échantillons phosphatés par MEB. Les résultats sont indiqués dans le tableau ci-dessous :

| Echantillon | 7 | 8 | 9 |
|---|---|---|---|
| Tôle d'acier | Usibor® AluSi® 14μm + zinc | Usibor® AluSi® 14μm + zinc | Usibor® AluSi® 14μm + zinc |
| Type de dépôt | Zn déposé par électrodéposition | Zn déposé par électrodéposition | Zn déposé par électrodéposition |
| Epaisseur couche | 0,5μm | 1,0μm | 1,5μm |
| Taux de couvrance | >95% | >95% | >98% |

On remarque que tous les échantillons présentent un taux de couvrance élevé des cristaux de phosphate sur la surface de la pièce durcie.

Exemple 2 : Test d'adhérence de la couche de cataphorèse:

Cette méthode sert à déterminer l'adhérence de la couche de cataphorèse déposée sur la pièce durcie sous presse.

Une couche de cataphorèse de 20μm est déposée sur les échantillons 7 à 9 obtenus à l'Exemple 1c. A cet effet, on trempe les échantillons 7 à 9 dans un bain comprenant une solution aqueuse comprenant du Pigment paste® W9712 et du Resin blend® W7911 de la société PPG Industries. On applique une tension de 180 V pendant 180 secondes avec un gradient de tension de 0 à 180 V les 30 premières secondes. Une fois que le dépôt de cataphorèse est réalisé, la pièce est rincée à l'eau puis cuite dans un four à une température de 178°C pendant 30 minutes. On obtient ainsi des pièces durcies sous presse peintes.

Exemple 2a : Test d'adhérence en milieu sec ou « dry E-coat adhesion »:

On réalise un quadrillage sur les pièces peintes à l'aide d'un cutter. Ensuite, on évalue à l'oeil nu la peinture qui se décolle de la pièce: 0 signifie excellent, c'est-à-dire que la peinture ne se décolle pas et 5 signifie très mauvais, c'est-à-dire que la peinture est décollée à plus de 65%. Les résultats sont indiqués dans le tableau ci-dessous :

| Echantillon | 10 | 11 | 12 |
|---|---|---|---|
| Epaisseur Zn | 0,5μm | 1,0μm | 1,5μm |
| Adhérence peinture | 0 | 0 | 5 |

On remarque que l'adhérence de la peinture est excellente lorsque la pièce durcie est préparée à partir d'une tôle d'acier munie d'un revêtement de zinc dont l'épaisseur est de 0,5 ou 1,0μm. En revanche, lorsque la pièce durcie est préparée à partir d'une tôle d'acier dont l'épaisseur de la couche de zinc est de 1,5μm, l'adhérence de la couche de cataphorèse est très mauvaise.

Exemple 2b : Test d'adhérence en milieu humide ou « wet E coat adhesion »:

Tout d'abord, on immerge les pièces peintes dans une enceinte fermée comprenant de l'eau déminéralisée pendant 10 jours à une température de 50°C. Ensuite, on réalise le quadrillage décrit dans l'Exemple 2a. On obtient les résultats suivants :

| Echantillon | 13 | 14 | 15 |
|---|---|---|---|
| Epaisseur Zn | 0,5μm | 1,0μm | 1,5μm |
| Adhérence peinture | 0 | 1 | 4,5 |

On remarque que l'adhérence de la peinture est très bonne lorsque la pièce durcie est préparée à partir d'une tôle d'acier munie d'un revêtement de zinc dont l'épaisseur est de 0,5 ou 1,0μm. Par contre, lorsque la pièce durcie est préparée à partir d'une tôle d'acier dont l'épaisseur de la couche de zinc est de 1,5μm, l'adhérence de la couche de cataphorèse est mauvaise.

EP 3 259 380 B1

Exemple 3 : Test de corrosion :

Cette méthode sert à déterminer la résistance à la corrosion, en particulier la présence de rouille rouge, d'une pièce peinte.

Les échantillons 16 à 18 ont été préparés en appliquant le procédé décrit dans l'Exemple 2. Dans cet exemple, la couche de cataphorèse déposée a une épaisseur de 8 $\mu$m. A cet effet, le temps total de dépose de la cataphorèse est réduit à 30 secondes.

Ce test consiste à soumettre les pièces peintes à 6 cycles de corrosion selon la nouvelle norme VDA 231-102. Un cycle consiste à placer les échantillons dans une enceinte fermée dans laquelle une solution aqueuse de chlorure de sodium à 1% en poids est vaporisée sur les échantillons avec un débit de 3mL/h en faisant varier la température de 50 à -15°C et le taux d'humidité de 50 à 100%. Ce cycle est représenté Figure 5.

On évalue la présence de rouille rouge à l'oeil nu : 3 signifie excellent, en d'autres termes, il n'y a pas ou presque pas de rouille rouge et 0 signifie très mauvais, en d'autres termes, il y a beaucoup de rouille rouge.

| Echantillon | 16 | 17 | 18 |
|---|---|---|---|
| Epaisseur Zn | 0,5$\mu$m | 1,0$\mu$m | 1,5$\mu$m |
| Corrosion | 2,5 | 2,5 | 1 |

On remarque que lorsque la pièce peinte est préparée à partir d'une tôle d'acier munie d'un revêtement de zinc dont l'épaisseur est de 0,5 et 1,0$\mu$m, il y a une très bonne résistance à la rouille rouge. En revanche, lorsque la pièce peinte est préparée à partir d'une tôle d'acier munie d'un revêtement de zinc dont l'épaisseur est de 1,5$\mu$m, la résistance à la rouille rouille est mauvaise.

Les pièces durcies selon l'invention permettent donc une bonne adhérence de la peinture et ont une bonne résistance à la rouille rouge.

Exemple 4 : Test de collage :

Cette méthode sert à déterminer la force nécessaire à appliquer pour décoller deux aciers collés ensemble sous forme de sandwich. Ces aciers sont obtenus à partir de tôles d'acier Usibor® AluSi® étant non revêtues ou revêtues de zinc selon l'invention.

A cet effet, les échantillons 19 et 20 ont été obtenus à partir d'une tôle d'acier Usibor® AluSi® 14$\mu$m munie en outre d'un deuxième revêtement de zinc déposé par électrodéposition dont l'épaisseur est de 0,6$\mu$m.

Les échantillons 21 et 22 ont été obtenus à partir d'une tôle d'acier Usibor® AluSi® 25$\mu$m munie en outre d'un deuxième revêtement de zinc déposé par électrodéposition dont l'épaisseur est de 0,6$\mu$m.

Les échantillons 23 et 24 sont obtenus à partir d'une tôle d'acier Usibor® AluSi® 25$\mu$m.

Pour le dépôt de zinc par électrodéposition, tout d'abord, un premier dégraissage de la tôle est réalisé à l'aide d'une solution de Garboclean® S5170-S5093 à une température de 80°C par aspersion. Ensuite, un deuxième dégraissage est réalisé avec la même solution à une température de 40°C par immersion. Le dégraissage est suivi d'un rinçage à l'eau. Ensuite, un avivage est réalisé avec une solution d'acide sulfurique. L'avivage est suivi d'un rinçage à l'eau. La tôle est alors immergée dans un bain électrolytique comprenant $H_2SO_4$ et $ZnSO_4$.

Ensuite, dans chaque cas, on a découpé la tôle d'acier Usibor® AluSi® revêtue ou non revêtue de zinc pour obtenir un flan. Puis on a chauffé le flan à une température de 900°C pendant une durée allant de 5 ou 10 minutes. On a ensuite transféré le flan au sein d'une presse, puis on a embouti à chaud pour obtenir une pièce. Enfin, on a refroidi ladite pièce pour obtenir un durcissement par transformation martensitique.

Pour chacun des échantillons, deux tôles d'aciers équivalentes ont été collées à l'aide d'une colle crash nommée Betamate 1480V203G de la société DOW. Les échantillons ont ensuite été chauffés pendant 30 minutes à 180°C permettant ainsi le durcissement de la colle crash. Après refroidissement, une contrainte mécanique est exercée de part et d'autre de chacune des tôles afin de décoller les deux tôles d'acier. La contrainte moyenne de cisaillement à rupture est alors mesurée en Méga Pascal. Les résultats sont présentés dans le tableau ci-dessous :

| Echantillon | 19 | 20 | 21 | 22 | 23 | 24 |
|---|---|---|---|---|---|---|
| Tôle d'acier | Usibor® AluSi® 14μm + Zn | Usibor® AluSi® 14μm + Zn | Usibor® AluSi® 25μm+ Zn | Usibor® AluSi® 25μm + Zn | Usibor® AluSi® 25μm | Usibor® AluSi® 25μm |
| Durée chauffage à 900°C | 5 minutes | 10 minutes | 5 minutes | 10 minutes | 5 minutes | 10 minutes |
| Type de dépôt | Zn déposé par électrodéposition | Zn déposé par électrodéposition | Zn déposé par électrodéposition | Zn déposé par électrodéposition | x | x |
| Epaisseur couche | 0,6μm±0,2μm | 0,6μm±0,2μm | 0,6μm±0,2μm | 0,6μm±0,2μm | x | x |
| Contrainte mécanique (MPa) | 39 | 38 | 37 | 37 | 37 | 38 |

On remarque qu'une haute contrainte de cisaillement à rupture est obtenue pour chaque échantillon. Ainsi, pour les échantillons 19 à 22, cela signifie que les interfaces liées au revêtement de Zn, c'est-à-dire l'interface entre le revêtement à base d'aluminium et la couche de ZnO obtenue lors du traitement thermique et l'interface entre cette même couche de ZnO et la colle crash, ne sont pas fragiles.

Exemple 5 : Test d'hydrogène diffusif :

Cette méthode sert à déterminer la quantité d'hydrogène absorbée pendant le traitement thermique d'austénitisation.

L'échantillon 25 a été obtenu à partir d'une tôle d'acier Usibor® AluSi® 25µm munie en outre d'un deuxième revêtement de zinc déposé par électrodéposition dont l'épaisseur est de 0,6µm.

L'échantillon 26 est obtenu à partir d'une tôle d'acier Usibor® AluSi® 25µm.

Pour le dépôt de zinc par électrodéposition, le procédé décrit dans l'exemple 4 a été reproduit.

Ensuite, pour chaque échantillon, on a découpé la tôle d'acier Usibor® AluSi® revêtue ou non revêtue de zinc pour obtenir un flan. Puis on a chauffé le flan à une température de 900°C pendant une durée de 6 minutes et 30 secondes. On a ensuite transféré le flan au sein d'une presse, puis on a embouti à chaud pour obtenir une pièce. Enfin, on a refroidi ladite pièce pour obtenir un durcissement par transformation martensitique.

Enfin, la mesure de la quantité d'hydrogène absorbée par les échantillons pendant le traitement thermique a été réalisée par désorption thermique à l'aide d'un TDA ou Thermal Desorption Analyser. A cet effet, chaque échantillon, placé dans une enceinte en quartz, est chauffé lentement dans un four à infra-rouge sous un flux d'azote. Le mélange hydrogène/azote dégagé est capté par un détecteur de fuite et la concentration en hydrogène est mesurée par un spectromètre de masse. Les résultats sont présentés dans le tableau ci-dessous :

| Echantillon | 25 | 26 |
|---|---|---|
| Tôle d'acier | Usibor® AluSi® 25µm+ Zn | Usibor® AluSi® 25µm |
| Durée chauffage à 900°C | 6 minutes 30 secondes | 6 minutes 30 secondes |
| Type de dépôt | Zn déposé par électrodéposition | x |
| Epaisseur couche | 0,6µm±0,2µm | x |
| Quantité d'hydrogène désorbée (ppm) | 0,2 | 0,15 |

On remarque que la quantité d'hydrogène diffusif désorbée est similaire que l'échantillon soit une tôle d'acier non revêtue ou revêtue de zinc selon l'invention.

Exemple 6 : Test de Soudage :

Exemple 6a : Domaine de soudage

Cette méthode sert à déterminer le domaine d'intensité de soudage valide pour un échantillon, c'est-à-dire la gamme d'intensité dans laquelle le soudage par point peut être réalisé sans inconvénient tel que l'expulsion du métal provenant du revêtement métallique. Le domaine de soudage doit être généralement supérieur à 1kA dans le cahier des charges des constructeurs automobiles.

L'échantillon 27 a été obtenu à partir d'une tôle d'acier Usibor® AluSi® 14µm munie en outre d'un deuxième revêtement de zinc déposé par électrodéposition dont l'épaisseur est de 0,6µm.

Pour le dépôt par électrodéposition, le procédé décrit dans l'exemple 4 a été reproduit.

Ensuite, l'échantillon a été découpé pour obtenir un flan. Le flan a été chauffé à une température de 900°C pendant une durée de 5 minutes et 30 secondes. On a ensuite transféré le flan au sein d'une presse, puis on a embouti à chaud pour obtenir une pièce. Enfin, ladite pièce a été refroidie pour obtenir un durcissement par transformation martensitique.

L'échantillon 28 a été préparé en appliquant le procédé décrit dans l'Exemple 5.

Dans ce test, pour chacun des échantillons, deux tôles d'acier équivalentes ont été soudés par point. A cet effet, des électrodes sont placées de part et d'autre de chaque tôle d'acier revêtues selon l'invention. Une force de compression de 450 daN est appliquée entre les électrodes. Un courant alternatif d'une fréquence de 50Hz appliqué aux électrodes traverse l'échantillon permettant ainsi de souder les deux tôles d'acier. Par ailleurs, une intensité de 3kA est fixée en début de test et est augmentée progressivement jusqu'à déterminer l'intensité maximale (Imax) à partir de laquelle du métal fondu est expulsé. Ensuite, l'intensité est progressivement diminuée pour déterminer l'intensité minimale (Imin) à partir de laquelle le diamètre de point soudé est inférieur à la valeur seuil autorisée. Le domaine de soudage est limité par Imax et Imin. Les résultats sont présentés dans le tableau ci-dessous :

| Echantillon | 27 | 28 |
|---|---|---|
| Tôle d'acier | Usibor® AluSi® 14$\mu$m + Zn | Usibor® AluSi® 25$\mu$m+ Zn |
| Durée chauffage à 900°C | 5 minutes 30 secondes | 6 minutes 30 secondes |
| Type de dépôt | Zn déposé par électrodéposition. | Zn déposé par électrodéposition |
| Epaisseur couche de Zn | 0,6$\mu$m$\pm$0,2$\mu$m | 0,6$\mu$m$\pm$0,2$\mu$m |
| Domaine d'intensité de soudage (kA) | 1.6kA | 1.4kA |

On remarque que le domaine de soudage de chaque échantillon est supérieur à 1kA.

Exemple 6b : Propriétés mécaniques

Cette méthode sert à déterminer les propriétés mécaniques d'un point soudé. A cet effet, on applique une contrainte mécanique sur un point soudé jusqu'à ce qu'il y ait rupture.

Les échantillons 29 et 31 sont respectivement les échantillons 27 et 28 de l'Exemple 6a.

Les échantillons 30 et 32 sont obtenus respectivement à partir de tôles d'acier Usibor® AluSi® 14$\mu$m et Usibor® AluSi® 25$\mu$m.

Dans ce test, les échantillons sont composés de deux tôles d'acier équivalentes soudées sous forme de croix. Une force est appliquée de manière à rompre le point soudé. Cette force, appelée Cross Tensile Strength (CTS), est exprimée en daN. Elle dépend du diamètre du point soudé et de l'épaisseur métal, c'est-à-dire l'épaisseur de l'acier et du revêtement métallique. Elle permet de calculer le coefficient $\alpha$ qui est le rapport de la valeur de CTS sur le produit du diamètre du point soudé multiplié par l'épaisseur du substrat. Ce coefficient est exprimé en daN/mm$^2$. Les résultats sont présentés dans le tableau ci-dessous :

| Echantillon | 29 | 30 | 31 | 32 |
|---|---|---|---|---|
| Tôle d'acier | Usibor® AluSi® 14$\mu$m + Zn | Usibor® AluSi® 14$\mu$m | Usibor® AluSi® 25$\mu$m+ Zn | Usibor® AluSi® 25$\mu$m |
| Durée chauffage à 900°C | 5 minutes 30 secondes | 5 minutes 30 secondes | 6 minutes 30 secondes | 6 minutes 30 secondes |
| Type de dépôt | Zn déposé par électrodéposition | x | Zn déposé par électrodéposition | x |
| Epaisseur couche | 0,6$\mu$m$\pm$0,2$\mu$m | x | 0,6$\mu$m$\pm$0,2$\mu$m | x |
| $\alpha$ (daN/mm$^2$) | 72 | 68 | 70 | 70 |

On remarque que les coefficients $\alpha$ pour les échantillons 29 et 30 et pour les échantillons 31 et 32 sont similaires.

Exemple 6c : Durée de vie des électrodes

Cette méthode sert à déterminer la durée de vie des électrodes, c'est-à-dire le nombre de points soudés qui peut être réalisé avec une paire d'électrodes avant que les électrodes ne soient trop dégradées et que la qualité des points soudés ne soit plus acceptable.

Les échantillons 33 et 34 sont respectivement les échantillons 27 et 28 de l'Exemple 6a.

Dans ce test, il suffit de réaliser avec une même paire d'électrodes des points soudés et de mesurer leurs diamètres tous les 100 points. En effet, plus on utilise une paire d'électrodes pour souder, plus le diamètre des points soudés va diminuer. Il y a donc un diamètre critique de points soudés dans le cahier des charges des constructeurs automobiles. Il est généralement décrit comme étant 4x$\sqrt{t}$ avec t étant l'épaisseur métal, c'est-à-dire l'épaisseur de la tôle en mm. En dessous de ce diamètre, on estime de l'électrode est usée.

On a donc mesuré le diamètre des points soudés en fonction du nombre de points réalisés. L'épaisseur métal des échantillons 33 et 34 étant de 1,5 mm, le diamètre critique du point soudé est 4,89 mm. Les essais ont été arrêtés après 1000 points soudés. Les résultats sont dans le tableau ci-dessous :

| | Nombre de points soudés | | | | | |
|---|---|---|---|---|---|---|
| | 200 | 400 | 600 | 800 | 1000 | Echantillons |
| Diamètre points soudés (mm) | 6,45 | 6,55 | 6,40 | 5,8 | 5,6 | 33 |
| | 6,7 | 6,6 | 6,6 | 6,40 | 6,3 | 34 |

On remarque que le diamètre des points soudés est bien au-dessus de la valeur limite de 4,89mm pour tous les points réalisés. Par ailleurs, on remarque que le diamètre des points diminue très peu de 200 à 1000 points.

**Revendications**

1. Tôle d'acier, pour durcissement sous presse, revêtue d'un revêtement à base d'aluminium comprenant en outre un deuxième revêtement de zinc dont l'épaisseur est inférieure ou égale à 1,1 $\mu$m.

2. Tôle d'acier selon la revendication 1, dans laquelle l'épaisseur du revêtement de zinc est inférieure ou égale à 1,0$\mu$m.

3. Tôle d'acier selon la revendication 2, dans laquelle l'épaisseur du revêtement de zinc est inférieure ou égale à 0,7$\mu$m.

4. Tôle d'acier selon l'une quelconque des revendications 1 à 3, dans laquelle le revêtement à base d'aluminium comprend jusqu'à 3% de fer et de 9 à 12% de silicium, le reste étant de l'aluminium.

5. Tôle d'acier selon l'une quelconque des revendications 1 à 4, dans laquelle la tôle d'acier est recouverte sur au moins une face d'un revêtement à base d'aluminium dont l'épaisseur est comprise entre 5 et 50$\mu$m.

6. Tôle d'acier selon l'une quelconque des revendications 1 à 5, dans laquelle le revêtement à base d'aluminium est directement en contact avec le revêtement de zinc.

7. Tôle d'acier selon l'une quelconque des revendications 1 à 6, selon laquelle le produit de l'épaisseur du revêtement à base d'aluminium et de l'épaisseur du revêtement de zinc est compris entre 2 et 25.

8. Tôle d'acier selon l'une quelconque des revendications 1 à 7, dont la composition pondérale est la suivante :

   $0,20\% \leq C \leq 0,25\%$
   $0,15\% \leq Si \leq 0,35\%$
   $1,10\% \leq Mn \leq 1,40\%$
   $0\% \leq Cr \leq 0,30\%$
   $0\% \leq Mo \leq 0,35\%$
   $0\% \leq P \leq 0,025\%$
   $0\% \leq S \leq 0,005\%$
   $0,020\% \leq Ti \leq 0,060\%$
   $0,020\% \leq Al \leq 0,060\%$
   $0,002\% \leq B \leq 0,004\%$,

   le reste de la composition étant constituée de fer et d'impuretés inévitables résultant de l'élaboration.

9. Tôle d'acier selon l'une quelconque des revendications 1 à 7, dont la composition pondérale est la suivante :

   $0,24\% \leq C \leq 0,38\%$
   $0,40\% \leq Mn \leq 3\%$
   $0,10\% \leq Si \leq 0,70\%$
   $0,015\% \leq Al \leq 0,070\%$
   $0\% \leq Cr \leq 2\%$
   $0,25\% \leq Ni \leq 2\%$
   $0,020\% \leq Ti \leq 0,10\%$

0% ≤ Nb ≤ 0,060%
0,0005% ≤ B ≤ 0,0040%
0,003% ≤ N ≤ 0,010%
0,0001% ≤ S ≤ 0,005%
0,0001% ≤ P ≤ 0,025%

étant entendu que les teneurs en titane et en azote satisfont à :

Ti/N > 3,42,

et que les teneurs en carbone, manganèse, chrome et silicium satisfont à :

$$2,6C + \frac{Mn}{5,3} + \frac{Cr}{13} + \frac{Si}{15} \geq 1,1\%$$

la composition comprenant optionnellement un ou plusieurs des éléments suivants :

0,05% ≤ Mo ≤ 0,65%
0,001 % ≤ W ≤ 0,30%
0,0005% ≤ Ca ≤ 0,005%,

le reste de la composition étant constituée de fer et d'impuretés inévitables résultant de l'élaboration.

**10.** Procédé de préparation d'une tôle d'acier selon l'une quelconque des revendications 1 à 9, dans lequel on effectue le revêtement de zinc par cémentation, par électrodéposition, ou par dépôt sous vide par jet de vapeur sonique.

**11.** Procédé de fabrication selon la revendication 10, dans lequel lorsque le revêtement de zinc est déposé par cémentation ou électrodéposition, ledit revêtement est directement déposé sur le revêtement à base d'aluminium.

**12.** Procédé selon la revendication 11, dans lequel le revêtement de zinc déposé par cémentation est réalisé par immersion ou par aspersion.

**13.** Procédé selon la revendication 11, dans lequel lorsque le revêtement est déposé sous vide par jet de vapeur sonique, une fine couche d'acier inoxydable est déposée entre le revêtement à base d'aluminium et le revêtement de zinc.

**14.** Procédé de préparation d'une pièce durcie sous presse revêtue d'un revêtement phosphatable comprenant les étapes successives selon lesquelles:

    A) on approvisionne une tôle d'acier, pour durcissement sous presse, selon l'une quelconque des revendications 1 à 9 ou fabriquée par un procédé selon l'une quelconque des revendications 10 à 13,
    B) on découpe la tôle obtenue à l'étape A) pour obtenir un flan, puis
    C) on chauffe le flan à une température T1 allant de 840 à 950°C pour obtenir une structure totalement austénitique dans l'acier,
    D) on transfère ensuite le flan au sein d'une presse,
    E) on emboutit à chaud le flan pour obtenir une pièce,
    F) on refroidit la pièce obtenue à l'étape E) pour obtenir une structure dans l'acier martensitique ou martensito-bainitique ou constituée d'au moins 75% de ferrite équiaxe, de martensite en quantité supérieure ou égale à 5% et inférieure ou égale à 20%, de bainite en quantité inférieure ou égale à 10%.

**15.** Procédé selon la revendication 14, dans lequel l'étape C) est mise en oeuvre pendant un temps t1 allant de 3 à 12 minutes dans une atmosphère inerte ou une atmosphère comprenant de l'air.

**16.** Procédé selon la revendication 14 ou 15, dans lequel lors de l'étape E), on emboutit à chaud à une température T2 allant de 600 à 830°C.

**17.** Pièce durcie susceptible d'être obtenue par un procédé selon l'une quelconque des revendications 14 à 16, comprenant une couche de ZnO et en outre une couche de cristaux de phosphate sur la couche de ZnO obtenue après une étape additionnelle G) de phosphatation.

**18.** Pièce selon la revendication 17, dans laquelle le taux de couvrance des cristaux de phosphate sur la surface de la pièce est supérieur ou égal à 90%.

**19.** Pièce selon la revendication 18, dans laquelle le taux de couvrance des cristaux de phosphate sur la surface de la pièce est supérieur ou égal à 99%.

**20.** Pièce selon l'une quelconque des revendications 17 à 19, comprenant en outre une couche de cataphorèse sur la couche de cristaux de phosphate.

**21.** Utilisation d'une pièce durcie sous presse selon l'une quelconque des revendications 17 à 20, ou fabriquée par un procédé selon l'une quelconque des revendications 14 à 16, pour la fabrication de pièces de véhicules automobiles.

**Patentansprüche**

**1.** Stahlblech für Press-Härtung, das beschichtet ist mit einer Beschichtung auf Aluminiumbasis, ferner aufweisend eine zweite Beschichtung aus Zink, deren Dicke kleiner oder gleich 1,1 $\mu$m ist.

**2.** Stahlblech gemäß Anspruch 1, wobei die Dicke der Zink-Beschichtung kleiner oder gleich 1,0 $\mu$m ist.

**3.** Stahlblech gemäß Anspruch 2, wobei die Dicke der Zink-Beschichtung kleiner oder gleich 0,7 $\mu$m ist.

**4.** Stahlblech gemäß irgendeinem der Ansprüche 1 bis 3, wobei die Beschichtung auf Aluminiumbasis aufweist wenigstens 3% Eisen und 9 bis 12% Silizium, wobei der Rest Aluminium ist.

**5.** Stahlblech gemäß irgendeinem der Ansprüche 1 bis 4, wobei das Stahlblech auf wenigstens einer Seite überzogen ist mit einer Beschichtung auf Aluminiumbasis, deren Dicke zwischen 5 und 50 $\mu$m liegt.

**6.** Stahlblech gemäß irgendeinem der Ansprüche 1 bis 5, wobei die Beschichtung auf Aluminiumbasis direkt in Kontakt mit der Zinkbeschichtung ist.

**7.** Stahlblech gemäß irgendeinem der Ansprüche 1 bis 6, wobei das Produkt der Dicke der Beschichtung auf Aluminiumbasis und der Dicke der Zink-Beschichtung zwischen 2 und 25 liegt.

**8.** Stahlblech gemäß irgendeinem der Ansprüche 1 bis 7, dessen Gewichts-Zusammensetzung die Folgende ist:

$0,20\% \leq C \leq 0,25\%$
$0,15\% \leq Si \leq 0,35\%$
$1,10\% \leq Mn \leq 1,40\%$
$0\% \leq Cr \leq 0,30\%$
$0\% \leq Mo \leq 0,35\%$
$0\% \leq P \leq 0,025\%$
$0\% \leq S \leq 0,005\%$
$0,020\% \leq Ti \leq 0,060\%$
$0,020\% \leq Al \leq 0,060\%$
$0,002\% \leq B \leq 0,004\%,$

wobei der Rest der Zusammensetzung gebildet ist aus Eisen und unvermeidbaren, aus der Bearbeitung resultierenden Verunreinigungen.

**9.** Stahlblech gemäß irgendeinem der Ansprüche 1 bis 7, dessen Gewichts-Zusammensetzung die Folgende ist:

$0,24\% \leq C \leq 0,38\%$
$0,40\% \leq Mn \leq 3\%$
$0,10\% \leq Si \leq 0,70\%$
$0,015\% \leq Al \leq 0,070\%$

$0\% \leq Cr \leq 2\%$
$0,25\% \leq Ni \leq 2\%$
$0,020\% \leq Ti \leq 0,10\%$
$0\% \leq Nb \leq 0,060\%$
$0,0005\% \leq B \leq 0,0040\%$
$0,003\% \leq N \leq 0,010\%$
$0,0001\% \leq S \leq 0,005\%$
$0,0001\% \leq P \leq 0,025\%,$

wobei die Gehalte von Titan und Stickstoff folgendes erfüllen:

$Ti/N > 3,42,$

und wobei die Gehalte von Kohlenstoff, Mangan, Chrom und Silizium folgendes erfüllen:

$$2,6C + Mn/5,3 + Cr/13 + Si/15 \geq 1,1\%,$$

wobei die Zusammensetzung optional aufweist ein oder mehrere der nachfolgenden Elemente:

$0,05\% \leq Mo \leq 0,65\%$
$0,001\% \leq W \leq 0,30\%$
$0,0005\% \leq Ca \leq 0,005\%,$

wobei der Rest der Zusammensetzung gebildet ist aus Eisen und unvermeidbaren, aus der Bearbeitung resultierenden Verunreinigungen.

10. Verfahren zur Bereitstellung eines Stahlblechs gemäß irgendeinem der Ansprüche 1 bis 9, wobei man die Zink-Beschichtung durch Einsatzhärtung, durch galvanische Beschichtung oder durch Vakuumabscheidung via Schallgasstrahl erzielt.

11. Verfahren zur Herstellung gemäß Anspruch 10, wobei, wenn die Zink-Beschichtung durch Einsatzhärtung oder galvanische Beschichtung aufgebracht wird, die Beschichtung direkt auf der Beschichtung auf Aluminiumbasis aufgebracht wird.

12. Verfahren gemäß Anspruch 11, wobei die Zink-Beschichtung, die durch Einsatzhärtung aufgebracht wird, durch Tauchen oder Besprengung realisiert wird.

13. Verfahren gemäß Anspruch 11, wobei, wenn die Beschichtung vakuumabgeschieden wird durch Schallgasstrahl, eine dünne nichtrostende Stahlschicht zwischen der Beschichtung auf Aluminiumbasis und der Zink-Beschichtung aufgebracht wird.

14. Verfahren zur Bereitstellung eines press-gehärteten Bauteils, das mit einer phosphatierbaren Beschichtung beschichtet ist, aufweisend die sukzessiven Schritte, gemäß denen:

   A) man bereitstellt ein Stahlblech für Press-Härtung gemäß irgendeinem der Ansprüche 1 bis 9 oder hergestellt durch ein Verfahren gemäß irgendeinem der Ansprüche 10 bis 13,
   B) man das im Schritt A) erlangte Blech schneidet zum Erlangen eines Rohlings,
   C) man dann den Rohling auf eine Temperatur T1, die von 840 bis 950%C geht, erhitzt zum Erzielen einer völlig austenitischen Struktur in dem Stahl,
   D) man dann den Rohling zu einer Presse überführt,
   E) man den Rohling heißpresst zum Erlangen eines Bauteils,
   F) man das im Schritt E) erlangte Bauteil abkühlt zum Erzielen, in dem Stahl, einer martensitischen oder martensitisch-bainitischen Struktur oder einer Struktur, die gebildet ist aus wenigstens 75% equiaxialem Ferrit, aus Martensit in einer Menge größer oder gleich 5% und kleiner oder gleich 20%, aus Bainit in einer Menge kleiner oder gleich 10%.

15. Verfahren gemäß Anspruch 14, wobei der Schritt C) während einer Zeit t1 durchgeführt wird, die 3 bis 12 Minuten dauert, in einer inerten Atmosphäre oder in einer Atmosphäre, die Luft aufweist.

16. Verfahren gemäß Anspruch 14 oder 15, wobei man während des Schritts E) bei einer Temperatur T2 heißpresst, die von 600 bis 830°C geht.

17. Gehärtetes Bauteil, das erhalten werden kann durch ein Verfahren gemäß irgendeinem der Ansprüche 14 bis 16, aufweisend eine Schicht aus ZnO und ferner eine Phosphatkristallschicht auf der Schicht aus ZnO, die erlangt ist nach einem zusätzlichen Phosphatier-Schritt G).

18. Bauteil gemäß Anspruch 17, wobei die Kristallphosphat-Bedeckungsquote auf der Fläche des Bauteils größer oder gleich 90% ist.

19. Bauteil gemäß Anspruch 18, wobei die Kristallphosphat-Bedeckungsquote auf der Fläche des Bauteils größer oder gleich 99% ist.

20. Bauteil gemäß irgendeinem der Ansprüche 17 bis 19, ferner aufweisend eine Kathaporese-Schicht auf der Kristallphosphat-Schicht.

21. Verwendung eines Bauteils, das pressgehärtet ist, gemäß irgendeinem der Ansprüche 17 bis 20 oder das hergestellt ist durch ein Verfahren gemäß irgendeinem der Ansprüche 14 bis 16 zur Herstellung von Kraftfahrzeugbauteilen.

**Claims**

1. Steel sheet for press hardening, coated with an aluminium-based coating and further comprising a second coating of zinc having a thickness of less than or equal to 1.1 $\mu$m.

2. Steel sheet according to claim 1, wherein the thickness of the zinc coating is less than or equal to 1.0 $\mu$m.

3. Steel sheet according to claim 2, wherein the thickness of the zinc coating is less than or equal to 0.7 $\mu$m.

4. Steel sheet according to any one of claims 1 to 3, wherein the aluminium-based coating comprises up to 3% iron and from 9 to 12% silicon, the remainder being aluminium.

5. Steel sheet according to any one of claims 1 to 4, wherein the steel sheet is covered on at least one face with an aluminium-based coating having a thickness of between 5 and 50 $\mu$m.

6. Steel sheet according to any one of claims 1 to 5, wherein the aluminium-based coating is directly in contact with the zinc coating.

7. Steel sheet according to any one of claims 1 to 6, wherein the product of the thickness of the aluminium-based coating and the thickness of the zinc coating is between 2 and 25.

8. Steel sheet according to any one of claims 1 to 7, having a weight composition as follows:

$$0.20\% \leq C \leq 0.25\%$$
$$0.15\% \leq Si \leq 0.35\%$$
$$1.10\% \leq Mn \leq 1.40\%$$
$$0\% \leq Cr \leq 0.30\%$$
$$0\% \leq Mo \leq 0.35\%$$
$$0\% \leq P \leq 0.025\%$$
$$0\% \leq S \leq 0.005\%$$
$$0.020\% \leq Ti \leq 0.060\%$$
$$0.020\% \leq Al \leq 0.060\%$$
$$0.002\% \leq B \leq 0.004\%,$$

the remainder of the composition being composed of iron and unavoidable impurities resulting from the production process.

9. Steel sheet according to any one of claims 1 to 7, having a weight composition as follows:

$0.24\% \leq C \leq 0.38\%$
$0.40\% \leq Mn \leq 3\%$
$0.10\% \leq Si \leq 0.70\%$
$0.015\% \leq Al \leq 0.070\%$
$0\% \leq Cr \leq 2\%$
$0.25\% \leq Ni \leq 2\%$
$0.020\% \leq Ti \leq 0.10\%$
$0\% \leq Nb \leq 0.060\%$
$0.0005\% \leq B \leq 0.0040\%$
$0.003\% \leq N \leq 0.010\%$
$0.0001\% \leq S \leq 0.005\%$
$0.0001\% \leq P \leq 0.025\%$,

it being understood that the amounts of titanium and nitrogen satisfy:

Ti/N > 3.42

and that the amounts of carbon, manganese, chromium and silicon satisfy:

$$2.6C + \frac{Mn}{5.3} + \frac{Cr}{13} + \frac{Si}{15} \geq 1.1 \%$$

the composition optionally comprising one or more of the following elements:

$0.05\% \leq Mo \leq 0.65\%$
$0.001\% \leq W \leq 0.30\%$
$0.0005\% \leq Ca \leq 0.005\%$,

the remainder of the composition being composed of iron and unavoidable impurities resulting from the production process.

10. Method for producing a steel sheet according to any one of claims 1 to 9, wherein the zinc coating is performed by cementation, by electroplating, or by sonic jet vapour deposition under vacuum.

11. Production method according to claim 10, wherein when the zinc coating is deposited by cementation or electroplating, said coating is deposited directly on the aluminium-based coating.

12. Method according to claim 11, wherein the zinc coating deposited by cementation is produced by immersion or by spraying.

13. Method according to claim 11, wherein when the coating is deposited under vacuum by sonic jet vapour, a thin layer of stainless steel is deposited between the aluminium-based coating and the zinc coating.

14. Method for producing a press-hardened part coated with a phosphatable coating, comprising the following successive steps:

A) providing a steel sheet for press-hardening according to any one of claims 1 to 9 or produced by a method according to any one of claims 10 to 13,
B) cutting the sheet obtained in step A) to obtain a blank, then
C) heating the blank at a temperature T1 ranging from 840 to 950°C to obtain a completely austenitic structure in the steel,
D) then transferring the blank to a press,
E) hot pressing the blank to obtain a part,
F) cooling the part obtained in step E) to obtain a structure in the steel which is martensitic or martensitic-bainitic or is composed of at least 75% equiaxed ferrite, martensite in an amount of greater than or equal to 5% and less than or equal to 20%, bainite in an amount of less than or equal to 10%.

**15.** Method according to claim 14, wherein step C) is carried out for a time t1 ranging from 3 to 12 minutes in an inert atmosphere or an atmosphere comprising air.

**16.** Method according to claim 14 or 15, wherein in step E) hot pressing is carried out at a temperature T2 ranging from 600 to 830°C.

**17.** Hardened part obtainable by a method according to any one of claims 14 to 16, comprising a ZnO layer and furthermore a phosphate crystal layer on the ZnO layer obtained after an additional phosphatation step G).

**18.** Part according to claim 17, wherein the degree of phosphate crystal coverage on the surface of the part is greater than or equal to 90%.

**19.** Part according to claim 18, wherein the degree of phosphate crystal coverage on the surface of the part is greater than or equal to 99%.

**20.** Part according to any one of claims 17 to 19, further comprising a cataphoresis layer on the phosphate crystal layer.

**21.** Use of a press-hardened part according to any one of claims 17 to 20, or produced by a method according to any one of claims 14 to 16, for manufacturing motor vehicle parts.

**Figure 1**

**Figure 2**

**Figure 3**

Figure 4

Figure 5

**EP 3 259 380 B1**

## RÉFÉRENCES CITÉES DANS LA DESCRIPTION

**Documents brevets cités dans la description**

- EP 2270257 A
- US 20120085466 A1